# FASCICULE DE BREVET EUROPEEN

(11) **EP 0 751 911 B1**
(45) Date de publication et mention de la délivrance du brevet: **10.06.1998**
(21) Numéro de dépôt: 95906366.0
(22) Date de dépôt: 05.01.1995
(51) Int. Cl.: C01B 21/072, C30B 25/00

(54) **PLAQUETTES A BASE DE NITRURE D'ALUMINIUM, PROCEDE DE PREPARATION ET UTILISATIONS**
PLÄTTCHEN AUS ALUMINIUM-NITRID, VERFAHREN ZU IHRER HERSTELLUNG UND IHRE VERWENDUNGEN
ALUMINIUM NITRIDE BASED PLATELETS, PROCESS FOR THEIR PREPARATION AND USE THEREOF

(30) Priorité: 14.01.1994 FR 9400373
(43) Date de publication de la demande: 08.01.1997
(73) Titulaire: ELF ATOCHEM S.A., 92800 Puteaux, Hauts-de-Seine (FR)
(72) Inventeur: DISSON, Jean-Pierre, F-69390 Vernaison (FR); BACHELARD, Roland, F-69007 Lyon (FR)
(86) Numéro de dépôt international: FR9500009
(87) Numéro de publication internationale: WO9519317

(56) Documents cités:
- EP-A- 0 425 325
- EP-A- 0 460 987
- EP-A- 0 519 806
- WO-A-91/19027
- US-A- 5 114 695
- JOURNAL OF MATERIALS SCIENCE, vol.25, 1990, LONDON GB, pages 2359-2361; TSUGE ET AL: 'raw material effect on AlN powder synthesis...'

## Description

L'invention a pour objet des macrocristaux renfermant du nitrure d'aluminium se présentant sous forme de plaquettes polygonales polycristallines, un procédé de préparation desdits macrocristaux par carbonitruration à partir d'alumine et leurs utilisations.

On connaît des procédés de préparation de macrocristaux à base de nitrure d'aluminium (AIN).

HORIUCHI et al. (J. Cryst. Growth, 21 (1), pp. 17-22, 1974) décrivent des monocristaux d'AIN d'aspect tabulaire présentant une taille de l'ordre de 100 µm, ces monocristaux étant obtenus par sublimation-condensation d'une poudre d'AIN à 1800°C.

Dans US-A-5 190 738, on décrit des monocristaux d'AIN de taille comprise entre 10 et 100 µm, ces monocristaux étant obtenus par carbonitruration d'alumine en présence d'un promoteur de croissance cristalline.

TSUGE et al. (J. Mater. Sci., vol. 25, pp. 2359-61, 1990) décrivent des particules d'AIN constituées d'agrégats prismatiques obtenues par carbonitruration d'Al(OH)₃.

CHO et CHARLES (Materials Science and Technology, vol. 7, pp. 495-504, 1991) décrivent des particules prismatiques d'AIN d'environ 50 µm résultant de l'agglomération de grains de faible taille. Ces particules sont obtenues par carbonitruration d'Al(OH)₃.

Il a maintenant été trouvé de nouveaux macrocristaux renfermant de l'AIN, ces macrocristaux étant caractérisés en ce qu'ils se présentent sous forme de plaquettes polygonales polycristallines.

Parmi ces macrocristaux renfermant de l'AIN, on désigne plus particulièrement des macrocristaux constitués d'au moins 5 % en poids d'AIN et de préférence 60 % et mieux encore 80 %.

Parmi ces macrocristaux, l'invention concerne plus particulièrement des macrocristaux se présentant sous forme de plaquettes ayant un diamètre inférieur à 50 µm et de préférence variant de 2 à 40 µm et une épaisseur variant de 0,1 à 3 µm.

De préférence, l'invention concerne de tels macrocristaux présentant un diamètre variant de 2 à 15 µm et une épaisseur variant de 0,1 à 1 µm.

L'invention a également pour objet un procédé de fabrication d'AIN sous forme de plaquettes, notamment telles que définies ci-avant. Ce procédé qui met en oeuvre de l'alumine a par carbonitruration est caractérisé en ce que l'alumine se présente sous forme de plaquettes, monocristallines.

L'alumine du procédé selon l'invention est généralement choisie parmi les alumines a sous forme de plaquettes polygonales monocristallines présentant un diamètre variant de 1 à 50 µm et de préférence 2 à 40 pm et une épaisseur variant de 0,05 à 10 µm et de préférence 0,1 à 3 pm. Avantageusement, on utilise des plaquettes d'alumine présentant un diamètre inférieur à 20 µm et une épaisseur inférieure à 1,5 µm, de telles plaquettes ayant généralement une bonne réactivité chimique.

Selon une première variante, l'alumine du procédé de l'invention peut revêtir l'aspect d'une poudre. Une telle poudre peut être obtenue, par exemple, selon le mode de préparation décrit dans la demande de brevet EP-A-0 425 325 au nom de la Demanderesse.

Selon une deuxième variante, l'alumine du procédé de l'invention peut être mise en oeuvre sous la forme d'un corps poreux.

Un tel corps poreux peut, par exemple, être obtenu selon le mode de préparation décrit dans la demande de brevet EP-A-0 460 987 au nom de la Demanderesse.

Le carbone du procédé selon l'invention est généralement choisi parmi les noirs de carbone se présentant sous forme de poudre tels que le noir de lampe, le noir tunnel, le noir au four ou le noir d'acétylène, le charbon actif, le feutre de carbone ou de graphite et la poudre de graphite.

On peut avantageusement, dans le but de remplacer tout ou partie du noir de carbone, utiliser des composés dont la pyrolyse conduit à un résidu carboné tels que les résines phénoliques ou furanniques, les polyacrylonitriles, les pitchs de pétrole, les polysaccharides et les dérivés de la cellulose.

Le carbone peut également provenir, en totalité ou partiellement, d'un dépôt en phase vapeur, par exemple par décomposition thermique d'hydrocarbures linéaires saturés tels que le méthane ou insaturés tels que l'éthylène et l'acétylène ou aromatiques.

Dans la mise en oeuvre du procédé selon l'invention, on utilise généralement le carbone et l'alumine en quantités telles que le rapport molaire carbone/alumine est compris entre 0,18 et 20. On préfère en général procéder avec un rapport molaire compris entre 2 et 10. Des valeurs du rapport molaire supérieures à 20 ne présentent pas d'intérêt car elles conduisent à un fort excès de carbone résiduaire dont l'élimination s'avère coûteuse.

Selon la première variante du procédé, la poudre d'alumine et le carbone peuvent être mis en oeuvre soit tels quels, par exemple par un mélange intime, soit après avoir subi une mise en forme. Cette mise en forme, variable selon le type de réacteur utilisé, peut par exemple être réalisée par granulation, extrusion ou pressage.

Selon la deuxième variante du procédé, on procède en général en mettant en oeuvre le corps poreux et le carbone tels quels ou bien en réalisant une imprégnation préalable du corps poreux.

On peut par exemple réaliser une telle imprégnation en traitant le corps poreux par la résine décrite ci-avant susceptible de générer du carbone par pyrolyse.

On peut aussi soumettre le corps poreux à un traitement en phase vapeur en présence du composé précédemment cité capable de former un dépôt de carbone par décomposition thermique. Ce dépôt peut être réalisé à une température inférieure à celle requise pour la carbonitruration ou bien à la même température, le carbone étant alors consommé au fur et à mesure qu'il se dépose.

La réaction de carbonitruration est généralement effectuée en présence d'azote et/ou d'un gaz générant de l'azote tel que l'ammoniac.

La réaction de carbonitruration est généralement effectuée à une température comprise entre 1350 et 1900°C, et de préférence entre 1400 et 1600°C, pendant un temps suffisant pour obtenir des plaquettes renfermant de l'AIN. A titre purement indicatif, ce temps peut varier de 30 minutes à 15 heures selon le type de réacteur utilisé.

L'AIN obtenu selon le procédé de l'invention se présente sous forme de plaquettes polygonales polycristallines dont le carbone résiduaire éventuellement présent peut être éliminé par combustion dans l'air à une température comprise entre 500 et 800°C.

Ces plaquettes renfermant de l'AIN, dont l'état d'agglomération est variable selon que l'on utilise l'une ou l'autre variante du procédé, peuvent être désagrégées par traitement mécanique doux, par exemple par émottage ou broyage à l'aide d'un jet d'air.

Les plaquettes polygonales polycristallines renfermant de l'AIN, objet de la présente invention, sont susceptibles de nombreuses applications. Elles peuvent notamment être utilisées pour le renforcement de matériaux divers en particulier de matrices métalliques, céramiques ou polymériques.

De telles plaquettes renfermant de l'AIN sont aussi particulièrement recommandées pour augmenter la conductivité thermique de composites pour lesquels une orientation des particules d'AIN dans un plan donné est recherchée. A titre indicatif, on peut citer les composites à matrice polymère obtenus par exemple par emboutissage, laminage ou extrusion.

Les exemples suivants permettent d'illustrer l'invention.

### EXEMPLE 1

On introduit 63,5 g de noir d'acétylène (Y50, SN2A), 74,8 g de résine formophénolique (R3593, CECA) et 90,0 g d'alumine sous forme de plaquettes (grade T₁, Elf Atochem) dans un malaxeur à bras en Z. Les plaquettes d'alumine sont constituées de monocristaux d'alumine α sous forme de polygones (majoritairement d'hexagones) plus ou moins réguliers présentant un diamètre moyen compris entre 5 et 10 µm et une épaisseur comprise entre 0,2 et 0,6 µm.

Le mélange est extrudé pour former des granulés cylindriques présentant un diamètre de 3 mm qui sont ensuite séchés à l'air à 150°C afin de polymériser la résine.

On introduit 27 g de granulés secs dans un creuset en graphite de 3,5 cm de diamètre dont le fond est muni d'orifices de 2 mm de diamètre. Le creuset est placé au centre d'un tube d'alumine hermétiquement clos constituant le moufle d'un four tubulaire. L'une des extrémités du moufle est munie d'un orifice permettant l'introduction d'azote et l'autre extrémité est pourvue d'un conduit permettant l'évacuation des gaz de combustion et de l'excès d'azote.

Le four est chauffé à 1530°C sous courant d'azote (84 l/h) et la température est maintenue constante pendant 10 h. Après refroidissement du four, on élimine le carbone excédentaire présent dans les granulées par combustion dans l'air à 700°C.

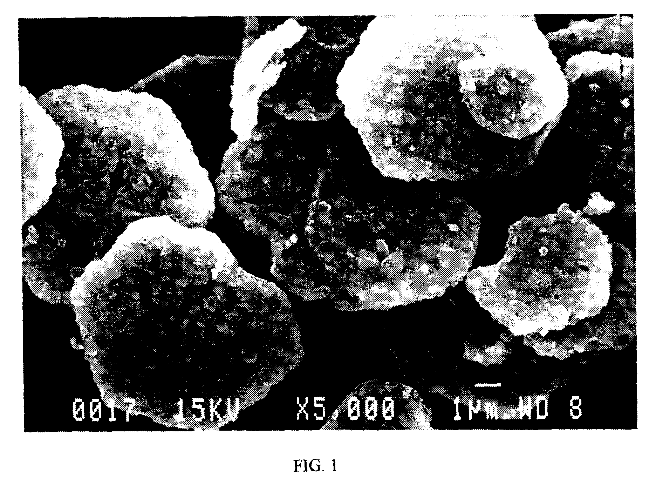

La poudre obtenue après désagrégation est constituée d'AIN sous forme de plaquettes présentant un diamètre le plus souvent compris entre 3 et 10 pm et une épaisseur comprise entre 0,2 et 0,7 µm (Figure 1, microscopie électronique à balayage). Certaines plaquettes sont percées. La teneur en oxygène de la poudre d'AIN, déterminée par fluorescence des rayons X, est de 1,1 %, ce qui correspond à une transformation quasi totale de l'alumine en nitrure d'aluminium.

### EXEMPLE 2

On introduit 5,2 g de noir d'acétylène (Y50, SN2A), 6,3 g de résine formophénolique (R3593, CECA) et 18,0 g d'alumine sous forme de plaquettes (grade T'₀, Elf Atochem) dans un malaxeur à couteaux. Ces plaquettes sont des monocristaux d'alumine α, de forme polygonale à majorité hexagonale présentant un diamètre compris entre 2 et 7 µm et une épaisseur comprise entre 0,1 et 0,5 µm.

Le mélange est pressé à 30 bars pour former une pastille qui est séchée à 150°C dans une étuve ventilée.

La pastille est introduite dans le four de l'exemple 1 chauffé à 1550°C sous azote (34 l/h) pendant 10 h. Après refroidissement du four, le carbone excédentaire de la pastille est éliminé par combustion dans l'air à 700°C.

Après désagrégation, on obtient une poudre dont la teneur en AIN, évaluée d'après les pertes en poids, est voisine de 100 %. L'AIN se présente sous forme de plaquettes de diamètre compris entre 2 à 7 µm dont la surface est très irrégulière. On constate que les bords des plaquettes hexagonales sont curvilignes et que quelques trous sont visibles sur certaines plaquettes.

### EXEMPLE 3

On procède dans les conditions de l'exemple 2 en présence d'alumine sous forme de plaquettes de grade T2 (Elf Atochem). Ces plaquettes d'alumine a, polygonales à majorité hexagonales, présentent un diamètre compris entre 10 et 16 µm et une épaisseur comprise entre 0,7 et 1,2 µm.

La poudre d'AIN obtenue se présente sous la forme de plaquettes de géométrie similaire à celle de l'alumine de départ. Le taux de transformation de l'alumine en AIN, évalué par pesée, est de 95 %. Les plaquettes présentent une surface irrégulière, des bords curvilignes et quelques trous sont présents.

### EXEMPLE 4

On utilise un corps poreux constitué d'alumine sous forme de plaquettes de grade T'₀ (Elf Atochem) obtenu selon le mode de préparation décrit dans la demande de brevet européen EP 0 460 987.

Le corps poreux (6,15 g; porosité : 78 %) (porosité calculée à partir de la détermination de la densité apparente de la préforme connaissant la densité absolue du matériau) est introduit dans un récipient pouvant être mis sous vide équipé à sa partie supérieure d'une ampoule de coulée remplie de résine formophénolique (R 3593, CECA). Après avoir réalisé le vide dans le récipient, on infiltre le corps poreux avec la résine. Le corps poreux imprégné est séché à 150°C et soumis à pyrolyse à 900°C sous atmosphère d'azote. La variation de poids du corps poreux indique que 2 g de carbone ont été déposés.

Le corps poreux imprégné est placé dans le four tubulaire de l'exemple 1 à une température de 1550°C et sous un débit d'azote de 30 l/h pendant 12 h. L'excès de carbone n'ayant pas réagi est éliminé par combustion dans l'air à 650°C. La fraction pondérale de l'AIN dans le produit, calculée sur la base des variations de poids, est égale à 70 %.

Après désagrégation, la poudre d'AIN se présente sous forme de plaquettes polygonales de surface irrégulière présentant un diamètre compris entre 2 et 7 µm et une épaisseur comprise entre 0,1 et 0,5 µm.

### EXEMPLE 5

On procède dans les conditions de l'exemple 4 en présence d'un corps poreux (3,4 g; porosité : 80,6 %) constitué d'alumine sous forme de plaquettes de grade T₂ (Elf Atochem). Après traitement par la résine, la quantité de carbone déposé sur le corps poreux est égale à 1,36 g.

La fraction pondérale de l'AIN dans le produit est de 63 %.

Après désagrégation, la poudre d'AIN se présente sous forme de plaquettes polygonales de surface irrégulière présentant un diamètre compris entre 12 et 16 pm et une épaisseur comprise entre 0,7 et 1,2 µm.

L'examen au microscope électronique à balayage avec sonde à éléments légers montre que l'alumine résiduaire est majoritairement localisée au coeur des plaquettes d'AIN.

### EXEMPLE 6

On procède dans les conditions de l'exemple 4 en présence d'un corps poreux pesant 8,2 g (porosité : 79,5 %) et d'une résine furannique (LQ 1300, Quaker Oats Chemicals). La viscosité de la résine étant élevée, on réalise l'imprégnation du corps poreux par la résine dans un dispositif maintenu à une température de 70°C.

La fraction pondérale de l'AIN dans le produit est de 61 %.

La poudre d'AIN présente les caractéristiques de la poudre décrite dans l'exemple 4.

### EXEMPLE 7

On utilise un corps poreux constitué d'alumine sous forme de plaquettes de grade T'0 (Elf Atochem) préparé selon le mode de réalisation décrit dans la demande de brevet EP 0 460 987.

Le corps poreux (6,7 g) est introduit dans le four tubulaire de l'exemple 1 chauffé à 1550°C pendant 12 h sous courant d'un mélange gazeux constitué d'azote et de méthane (90:10 v/v).

Le carbone excédentaire issu de la décomposition du méthane est éliminé par combustion dans l'air à 650°C.

La variation de poids au cours du traitement thermique indique une teneur en AIN de 61 %.

La poudre d'AIN présente des caractéristiques similaires à celles décrites à l'exemple 4, la surface des plaquettes étant toutefois plus régulière.

### EXEMPLE 8

On utilise un corps poreux constitué d'alumine sous forme de plaquettes de grade T₂ (Elf Atochem) obtenu selon le mode de préparation décrit dans la demande de brevet européen EP 0 460 987.

Le corps poreux (2,9 g; porosité : 80 %) est placé entre deux couches de feutre de graphite (RVG 4000, Carbone Lorraine) et l'ensemble est introduit dans un four de frittage dont l'atmosphère peut être contrôlée.

L'air du four de frittage est chassé et remplacé par de l'azote. Le four est porté en 2 h à 1800°C et maintenu à cette température pendant 4 h.

Après refroidissement, on constate qu'une partie du feutre de carbone entourant le corps poreux a disparu.

L'analyse du corps poreux par diffraction des rayons X indique que celui-ci est constitué d'AIN à 99 %. Après désagrégation, la poudre obtenue se présente sous la forme de plaquettes polygonales de surface irrégulière présentant un diamètre compris entre 10 et 16 µm et une épaisseur comprise entre 0,7 et 1,2 µm.

## Revendications

1. Macrocristaux renfermant du nitrure d'aluminium et se présentant sous forme de plaquettes polygonales polycristallines.

2. Macrocristaux selon la revendication 1 caractérisés en ce que les plaquettes sont constituées d'au moins 5 % de nitrure d'aluminium.

3. Macrocristaux selon la revendication 1 caractérisés en ce que les plaquettes sont constituées d'au moins 60 % de nitrure d'aluminium.

4. Macrocristaux selon la revendication 1 caractérisés en ce que les plaquettes sont constituées d'au moins 80 % de nitrure d'aluminium.

5. Macrocristaux selon l'une des revendications 1 à 4 caractérisés en ce que les plaquettes ont un diamètre inférieur à 50 µm.

6. Macrocristaux selon l'une des revendications 1 à 5 caractérisés en ce que les plaquettes ont un diamètre compris entre 2 et 40 µm et une épaisseur comprise entre 0,1 et 3 µm.

7. Macrocristaux selon l'une des revendications 1 à 6 caractérisés en ce que les plaquettes présentent un diamètre compris entre 2 et 15 µm et une épaisseur comprise entre 0,1 et 1 µm.

8. Procédé de préparation de macrocristaux de nitrure d'aluminium sous forme de plaquettes polycristallines caractérisé en ce que l'on fait réagir de l'alumine a sous forme de plaquettes monocristallines, du carbone et de l'azote par carbonitruration.

9. Procédé selon la revendication 8 caractérisé en ce que le diamètre des plaquettes d'alumine a est inférieur à 50 µm.

10. Procédé selon l'une des revendications 8 ou 9 caractérisé en ce que l'épaisseur des plaquette est comprise entre 0,1 et 3 µm.

11. Procédé selon l'une des revendications 8 à 10 caractérisé en ce que l'alumine a présente l'aspect d'une poudre.

12. Procédé selon l'une des revendications 8 à 10 caractérisé en ce que l'alumine α constitue un corps poreux.

13. Procédé selon la revendication 8 caractérisé en ce que l'on utilise un rapport molaire carbone/alumine compris entre 0,18 et 20.

14. Utilisation de macrocristaux selon l'une des revendications 1 à 7 pour le renforcement de matrices métalliques, céramiques ou polymériques.

## Patentansprüche

1. Makrokristalle, die Aluminiumnitrid enthalten und in Form polykristalliner polygonaler Täfelchen vorliegen.

2. Makrokristalle nach Anspruch 1, dadurch gekennzeichnet, daß die Täfelchen aus mindestens 5 % Aluminiumnitrid bestehen.

3. Makrokristalle nach Anspruch 1, dadurch gekennzeichnet, daß die Täfelchen aus mindestens 60 % Aluminiumnitrid bestehen.

4. Makrokristalle nach Anspruch 1, dadurch gekennzeichnet, daß die Täfelchen aus mindestens 80 % Aluminiumnitrid bestehen.

5. Makrokristalle nach einem der Ansprüche 1 bis 4, dadurch gekennzeichnet, daß die Täfelchen einen Durchmesser von weniger als 50 µm aufweisen.

6. Makrokristalle nach einem der Ansprüche 1 bis 5, dadurch gekennzeichnet, daß die Täfelchen einen Durchmesser zwischen 2 und 40 µm und eine Dicke zwischen 0,1 und 3 µm aufweisen.

7. Makrokristalle nach einem der Ansprüche 1 bis 6, dadurch gekennzeichnet, daß die Täfelchen einen Durchmesser zwischen 2 und 15 um und eine Dicke zwischen 0,1 und 1 µm aufweisen.

8. Verfahren zur Herstellung von Aluminiuninitridmakrokristallen in Form von polykristallinen Plättchen, dadurch gekennzeichnet, daß man α-Aluminiumoxid in Form von monokristallinen Plättchen, Kohlenstoff und Stickstoff durch Carbonitridierung miteinander reagieren läßt.

9. Verfahren nach Anspruch 8, dadurch gekennzeichnet, daß der Durchmesser der α-Aluminiumoxidplättchen kleiner als 50 µm ist.

10. Verfahren nach Anspruch 8 oder 9, dadurch gekennzeichnet, daß die Dicke der Plättchen zwischen 0,1 und 3 µm liegt.

11. Verfahren nach einem der Ansprüche 8 bis 10, dadurch gekennzeichnet, daß das α-Aluminiumoxid als Pulver vorliegt.

12. Verfahren nach einem der Ansprüche 8 bis 10, dadurch gekennzeichnet, daß das α-Aluminiumoxid einen porösen Körper darstellt.

13. Verfahren nach Anspruch 8, dadurch gekennzeichnet, daß man ein Kohlenstoff/Aluminiumoxid-Verhältnis zwischen 0,18 und 20 verwendet.

14. Verwendung von Makrokristallen nach einem der Ansprüche 1 bis 7 zur Verstärkung von Metall-, Keramik- und Polymermatrices.

## Claims

1. Macrocrystals containing aluminium nitride and being in the form of polycrystalline polygonal platelets.

2. Macrocrystals according to Claim 1, characterized in that the platelets consist of at least 5% of aluminium nitride.

3. Macrocrystals according to Claim 1, characterized in that the platelets consist of at least 60% of aluminium nitride.

4. Macrocrystals according to Claim 1, characterized in that the platelets consist of at least 80% of aluminium nitride.

5. Macrocrystals according to one of Claims 1 to 4, characterized in that the platelets have a diameter of less than 50 µm.

6. Macrocrystals according to one of Claims 1 to 5, characterized in that the platelets have a diameter of between 2 and 40 µm and a thickness of between 0.1 and 3 µm.

7. Macrocrystals according to one of Claims 1 to 6, characterized in that the platelets have a diameter of between 2 and 15 µm and a thickness of between 0.1 and 1 µm.

8. Process for preparing aluminium nitride macrocrystals in the form of polycrystalline platelets, characterized in that α-alumina in the form of monocrystalline platelets is made to react with carbon and with nitrogen by carbonitriding.

9. Process according to Claim 8, characterized in that the diameter of the α-alumina platelets is less than 50 µm.

10. Process according to either of Claims 8 and 9, characterized in that the thickness of the platelet is between 0.1 and 3 µm.

11. Process according to one of Claims 8 to 10, characterized in that the α-alumina has the appearance of a powder.

12. Process according to one of Claims 8 to 10, characterized in that the α-alumina constitutes a porous body.

13. Process according to Claim 8, characterized in that a carbon/alumina molar ratio of between 0.18 and 20 is used.

14. Use of macrocrystals according to one of Claims 1 to 7 for the reinforcement of metal, ceramic or polymer matrices.
